# FASCICULE DE BREVET EUROPEEN

(11) **EP 0 902 306 B1**
(45) Date de publication et mention de la délivrance du brevet: **04.12.2002**
(21) Numéro de dépôt: 98402233.5
(22) Date de dépôt: 10.09.1998
(51) Int. Cl.: G02B 6/12, G02B 6/42, H01S 5/10, H01S 5/02

(54) **Procédé de fabrication d'un composant optique intégré comprenant un guide d'onde épais couplé à un guide d'onde mince**
Herstellungsverfahren eines integrierten optischen Bauteils, bestehend aus einem dicken, an einen dünnen Wellenleiter gekoppelten Wellenleiter
Fabrication process of an optical integrated componant comprising a thick waveguide coupled with a thin waveguide

(30) Priorité: 11.09.1997 FR 9711298
(43) Date de publication de la demande: 17.03.1999
(73) Titulaire: ALCATEL, 75008 Paris (FR)
(72) Inventeur: Goldstein, Léon, 92370 Chaville (FR); Leclerc, Denis, 91430 Igny (FR); Dagens, Béatrice, 75014 Paris (FR)
(74) Mandataire: Fournier, Michel Robert Marie

(56) Documents cités:
- EP-A- 0 454 902
- PATENT ABSTRACTS OF JAPAN vol. 097, no. 010, 31 octobre 1997 & JP 09 152528 A (SHARP CORP), 10 juin 1997
- PATENT ABSTRACTS OF JAPAN vol. 095, no. 005, 30 juin 1995 & JP 07 043552 A (HITACHI CABLE LTD), 14 février 1995
- PATENT ABSTRACTS OF JAPAN vol. 097, no. 006, 30 juin 1997 & JP 09 036487 A (FUJITSU LTD), 7 février 1997
- PATENT ABSTRACTS OF JAPAN vol. 006, no. 229 (P-155), 16 novembre 1982 & JP 57 132105 A (NIPPON DENKI KK), 16 août 1982
- COLAS E. ET AL.: 'In situ definition of semiconductor stuctures by selective area growth and etching' APPLIED PHYSICS LETTERS vol. 59, no. 16, 14 Octobre 1991, pages 2019 - 2021

## Description

La présente invention se rapporte à un procédé de fabrication d'un composant optique intégré comprenant des guides d'onde ayant des structures différentes, et notamment des épaisseurs différentes. Ce procédé permet de minimiser les pertes de couplage à l'interface entre les deux types de guides et de réaliser une adaptation de modes.

Les composants optiques intégrés sont conçus pour renfermer notamment des guides d'onde passifs et actifs. Ces guides d'onde actif et passif sont intégrés sur un substrat selon une méthode dite de couplage bout à bout, encore dénommée "butt coupling" en terminologie anglo-saxonne.

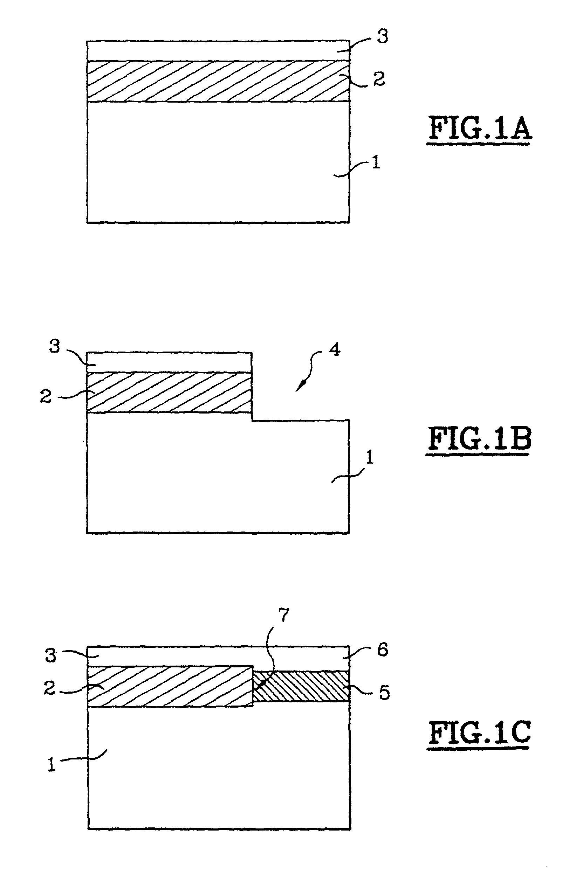

La méthode dite de "butt coupling", permettant de coupler un guide d'onde passif à un guide d'onde actif, est très courante aujourd'hui. Les schémas des figures 1A à 1C représentent des vues en coupe transversale dans le sens de la longueur d'un composant optique intégré au cours des différentes étapes de cette méthode de "butt coupling".

Cette méthode consiste, dans un premier temps, à faire croître, sur un substrat 1, une première couche de matériau quaternaire 2, apte à jouer le rôle de guide d'onde passif, et à l'enterrer dans une deuxième couche d'InP 3.

Une gravure locale 4 des deux couches 2 et 3 est ensuite pratiquée, selon un procédé de gravure classique, sur une zone réservée à l'intégration d'un autre guide d'onde de type actif.

Une reprise d'épitaxie permet de réaliser ce guide d'onde actif. Pour cela, une couche 5 constituant le guide d'onde, formée par exemple d'un matériau quaternaire, est déposée sur le substrat 1, dans la zone 4 gravée localement, puis elle est enterrée dans une couche de gaine 6 constituée par exemple d'InP. La structure du guide d'onde actif 5 est différente de celle du guide passif 2. L'interface de couplage 7 entre les deux types de guides d'onde est dénommée "butt joint" en terminologie anglo-saxonne.

La demande de brevet européen EP-A-454 902 constitue une illustration de cette méthode de « butt coupling » dans le cas où une structure verticale de laser est réalisée en premier sur toute la surface du substrat (figures 11 à 13). Cette structure qui comporte une couche active (correspondant à ce qui a été désigné précédemment par « guide d'onde actif ») est ensuite gravée localement sur une zone réservée à l'intégration d'une autre structure guidante de type passif (figures 14 à 16). Une étape d'épitaxie réalise ensuite la croissance de couches guidantes passives épaisses (correspondant à ce qui a été désigné précédemment par « guide d'onde passif » (figures 20 à 22).

Cette méthode- de fabrication est actuellement très bien maîtrisée lorsqu'il s'agit d'interface peu profonde, c'est-à-dire lorsque les épaisseurs des deux guides sont du même ordre de grandeur et, dans tous les cas, lorsque l'épaisseur du guide d'onde le plus épais n'excède pas 1µm.

En revanche, dans le cas d'une interface profonde, c'est-à-dire lorsque la gravure locale précédant la reprise d'épitaxie est réalisée sur une épaisseur supérieure ou égale à 1µm, des difficultés apparaissent et le procédé de fabrication devient difficile à maîtriser. De telles structures à interface profonde sont par exemple réalisées pour intégrer un guide d'onde insensible à la polarisation et un amplificateur optique en semi-conducteur dans un convertisseur de longueur d'onde de type Mach-Zehnder ou Michelson.

Dans les composants optiques à interface profonde entre les guides passif et actif, fabriqués selon les procédés de l'art antérieur, les modes de propagation présentent les mêmes dimensions dans les deux types de guide. Par conséquent, ces composants ne présentent en théorie aucune perte optique. Dans la réalité, la théorie n'est pas vérifiée car des pertes importantes apparaissent au niveau de l'interface 7. Ces pertes sont dues au fait que la reprise d'épitaxie, après une gravure profonde, devient très difficile à exécuter sans dégrader la qualité cristalline du matériau à déposer. Or, lorsque la qualité cristalline du matériau est affectée, des pertes de propagation lumineuse supérieures au dB et pouvant atteindre des valeurs bien supérieures (de quelques dizaines de dB) apparaissent au niveau de l'interface entre les deux types de guide.

D'autre part, la reprise d'épitaxie ne se faisant pas dans de bonnes conditions, un gros problème se pose pour aligner correctement les guides passif et actif dont les épaisseurs sont très différentes.

La présente invention permet de pallier aux inconvénients précités puisqu'elle propose un procédé de fabrication d'un composant optique intégré dans lequel on réalise le guide épais en deux étapes, de telle sorte que ce guide présente un gradient d'épaisseur afin de l'amincir et de transformer l'interface profonde entre les deux types de guide en une interface peu profonde.

L'invention a plus particulièrement pour objet un procédé de fabrication d'un composant optique intégré comprenant un guide d'onde épais couplé à un guide d'onde mince à travers une interface de couplage, caractérisé en ce qu'il consiste à :
- déposer, sur un substrat, une première couche guidante dudit guide épais,
- graver localement ladite première couche guidante sur une partie allouée à la fois à l'interface de couplage et au guide mince,
- déposer, sur la première couche guidante et sur la partie gravée localement, une deuxième couche guidante pour former ledit guide épais de telle sorte qu'il présente une épaisseur maximale dans une première zone, une section à gradient d'épaisseur dans une deuxième zone et une section amincie dans une troisième zone,
- graver localement la deuxième couche guidante sur une portion de la troisième zone, ladite portion étant allouée au guide mince et
- déposer, sur ladite portion gravée de ladite troisième zone, une troisième couche guidante formant ledit guide mince.

Ce procédé comporte une étape-de reprise d'épitaxie supplémentaire par rapport aux procédés classiques, mais il permet de diminuer progressivement l'épaisseur du guide d'onde épais de manière à ce que la transition avec le guide d'onde mince soit du même ordre de grandeur qu'une transition à interface peu profonde. Par conséquent les difficultés rencontrées lors d'une reprise d'épitaxie après une gravure profonde sont évitées.

Il est à noter que si l'interface de couplage forme avec l'axe optique, dans le plan des couches guidantes, un angle usuel de 90°, toute autre valeur d'angle peut être choisie, en particulier 45°.

Dans les composants optiques fabriqués selon le procédé objet de l'invention, le mode de propagation, qui est confiné dans la partie épaisse du guide épais, est lentement déconfiné au cours de la réduction d'épaisseur de ce guide. Par conséquent, il existe, à l'interface entre les deux types de guide, des pertes optiques intrinsèques dues au changement d'épaisseur. Ces pertes sont liées au fait que l'indice effectif du guide épais dans sa partie amincie, c'est-à-dire l'indice réel à l'interface entre le guide passif et le guide actif, est différent de l'indice du guide dans sa partie épaisse. Cependant ces pertes optiques restent bien inférieures à celles que l'on obtient expérimentalement avec les composants fabriqués selon les procédés de l'art antérieur puisqu'elles sont inférieures à 1 dB.

D'autres particularités et avantages de l'invention apparaîtront à la lecture de la description donnée à titre d'exemple illustratif mais non limitatif et faite en référence aux figures annexées qui représentent:
- les figures 1A à 1C, déjà décrites, des vues en coupe transversale dans le sens de la longueur d'un composant optique au cours des étapes d'un procédé classique de fabrication,

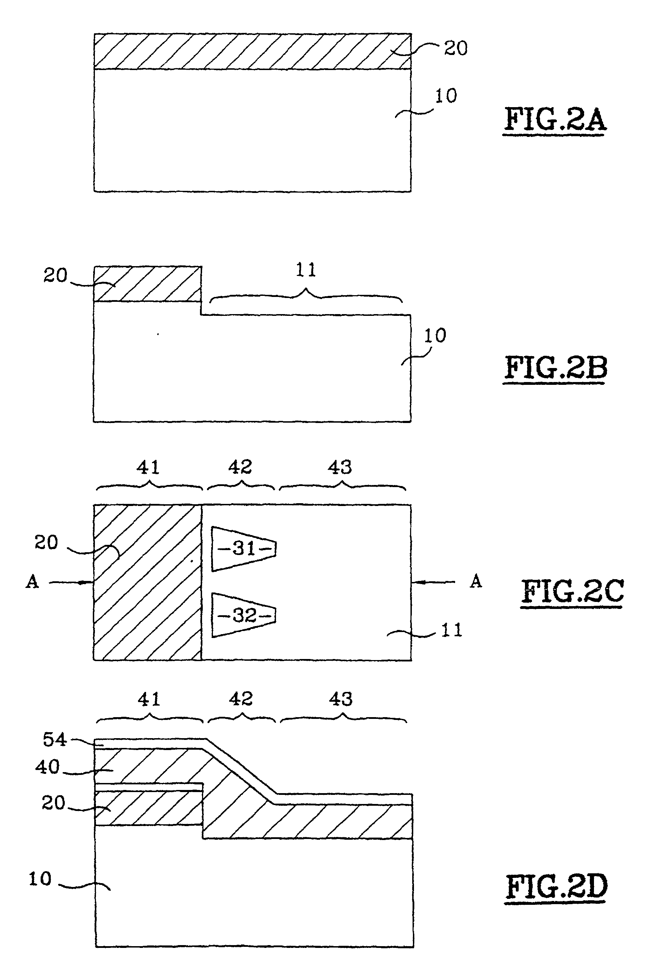

- les figures 2A à 2F, des vues d'un composant optique au cours des étapes d'un procédé de fabrication selon l'invention,

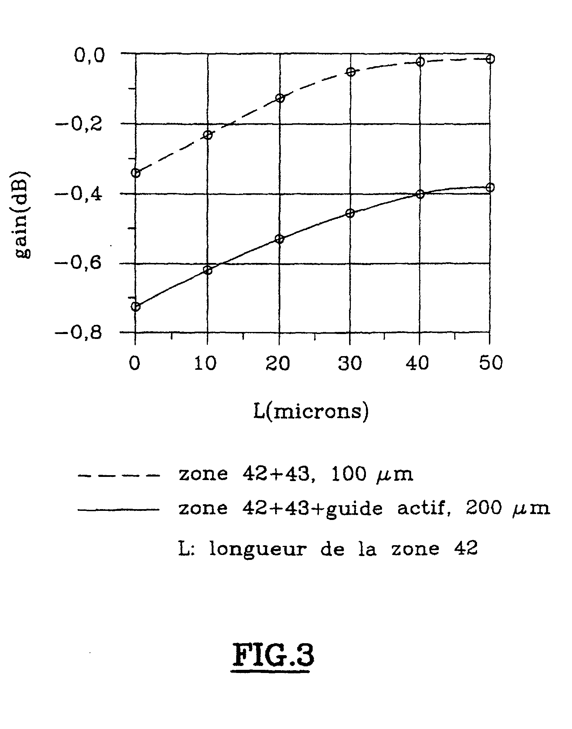

- la figure 3, deux courbes illustrant les pertes de propagation d'un composant selon l'invention, respectivement avec et sans guide d'onde mince, en fonction de la longueur de la section amincie du guide épais.

Dans l'exemple de réalisation décrit dans ce qui suit, le guide épais est un guide d'onde passif alors que le guide mince est un guide d'onde actif. Mais bien sûr l'invention ne se limite pas à cet exemple.

Un guide d'onde est défini comme étant épais lorsque son épaisseur est supérieure ou égale à 1µm. Par opposition, un guide mince est défini comme étant un guide présentant une épaisseur inférieure à 1µm.

Les figures 2A, 2B, et 2D à 2F représentent des vues en coupe transversale dans le sens de la longueur d'un composant optique au cours des différentes étapes du procédé selon l'invention, tandis que la figure 2C représente une vue de dessus de ce composant.

Une première étape du procédé selon l'invention, illustrée sur la figure 2A, consiste à déposer, sur un substrat 10, une première couche guidante 20 destinée à former une première partie du guide d'onde passif épais.

Dans une variante de réalisation, il est possible de déposer au préalable une couche tampon sur la surface du substrat de manière à supprimer les défauts superficiels éventuels du substrat.

L'épaisseur totale du guide d'onde passif à réaliser peut être comprise entre 1µm et 3µm. L'épaisseur de la première couche guidante 20 est de préférence comprise entre la moitié et les deux tiers de l'épaisseur totale de ce guide épais, c'est-à-dire qu'elle est comprise entre 0,5 et 2,1µm. Dans l'exemple illustré sur les figures 2A à 2F, la première couche guidante 20 est réalisée sur une épaisseur de 0,5µm, égale à la moitié de l'épaisseur totale du guide passif à réaliser. De plus, la première couche guidante 20 est par exemple réalisée dans un matériau quaternaire, tel qu'un matériau de type GaInAsP par exemple.

La première couche guidante 20 est ensuite gravée localement (figure 2B) selon un procédé classique de gravure sèche. Cette gravure est effectuée sur une partie 11 réservée à la fois au guide d'onde mince actif à réaliser et à l'interface de couplage entre les deux types de guides épais et mince. Dans cette partie 11, le substrat 10 peut en outre être partiellement gravé comme illustré sur la figure 2B.

Une reprise d'épitaxie est réalisée dans une étape ultérieure afin de déposer, sur la première couche guidante 20 et sur la partie gravée 11, une deuxième couche guidante 40. Cette étape, illustrée par les figures 2C et 2D, permet de former le guide passif de manière à ce qu'il présente une épaisseur maximale dans une première zone 41, une section à gradient d'épaisseur dans une deuxième zone 42, et une section amincie dans une troisième zone 43. La deuxième couche guidante 40 est réalisée dans le même matériau que la première couche guidante 20 et forme la deuxième partie du guide épais.

Pour pouvoir former la section à gradient d'épaisseur du guide d'onde passif, on réalise une épitaxie dite sélective. Pour cela, on place sur le substrat 10, dans la partie gravée 11, à l'emplacement de la deuxième zone 42, deux masques diélectriques 31, 32 sur lesquels ne se dépose pas le matériau quaternaire constituant la deuxième couche guidante (figure 2C).

Les deux masques 31, 32 sont placés cote à cote et il se crée une survitesse de croissance de la deuxième couche guidante 40 entre ces deux masques. Une surépaisseur se forme donc entre les masques 31, 32. Par conséquent, dans les première et troisième zones 41 et 43 situées de part et d'autre des masques, la vitesse de dépôt est nominale, alors que cette vitesse est significativement accélérée dans la deuxième zone 42 et plus particulièrement entre les masques 31, 32. Cette survitesse est d'autant plus grande que l'écart entre les masques est faible.

De préférence, les masques 31, 32 présentent une forme trapézoïdale et sont placés cote à cote de telle sorte que la distance les séparant soit relativement faible à proximité de la première zone 41, correspondant à la section d'épaisseur maximale, et augmente lentement lorsque l'on s'éloigne de cette première zone 41 pour se rapprocher de la troisième zone 43 correspondant à la section amincie. Cette forme particulière trapézoïdale des masques 31, 32 et leur disposition permet ainsi de créer un gradient de vitesse de dépôt de la deuxième couche guidante 40 et de former une section à gradient d'épaisseur dans le guide passif, entre les première et troisième zones 41 et 43 correspondant respectivement à la section épaisse et à la section amincie du guide d'onde.

La forme trapézoïdale des masques 31, 32 et leur disposition sont choisies de manière à obtenir un gradient de vitesse de croissance de la deuxième couche guidante 40 adapté au gradient d'épaisseur désiré. Ainsi, l'écart entre les masques varie par exemple de 15µm à 100µm sur une longueur de l'ordre de 50µm.

Les masques sont par exemple réalisés en silice (SiO₂) ou encore en nitrure de silicium (Si₃N₄).

La figure 2D représente une vue en coupe longitudinale selon A-A de la figure 2C. Dans l'exemple illustré sur cette figure, la deuxième couche guidante 40 est réalisée sur une épaisseur de 0,5µm, égale à la moitié de l'épaisseur totale du guide passif à réaliser.

L'empilement formé par la première couche guidante 20 et la deuxième couche guidante 40 constitue la première zone 41 dans laquelle l'épaisseur du guide d'onde est maximale et égale à 1µm dans l'exemple.

Dans la deuxième zone 42, l'épaisseur de ce guide diminue lentement, selon le gradient d'épaisseur réalisé de la manière précédemment décrite. Ce gradient d'épaisseur est adapté pour obtenir une transition du mode de propagation à l'intérieur de la structure du guide passif qui soit la plus adiabatique possible, c'est-à-dire pour éviter le plus possible des pertes optiques dues au changement de la structure du guide et notamment au changement d'épaisseur du guide.

L'épaisseur du guide passif est diminuée jusqu'à ce qu'il présente une épaisseur amincie et constante dans la troisième zone 43. L'épaisseur du guide dans cette zone 43 est en fait égale à l'épaisseur de la deuxième couche guidante 40 située au dessus de la première couche guidante 20 dans la première zone 41 du guide. Pour que l'interface de couplage entre les guides actif et passif corresponde à une interface peu profonde, il faut donc que l'épaisseur du guide dans sa partie amincie (zone 43), c'est-à-dire l'épaisseur de la deuxième couche guidante 40, ne dépasse pas 1µm. C'est pourquoi, l'épaisseur de la deuxième couche guidante 40 est de préférence comprise entre le tiers et la moitié de l'épaisseur totale du guide passif dans sa partie la plus épaisse (zone 41). Cette épaisseur est donc comprise entre 0,5 et 0,9µm.

L'épaisseur du guide épais est donc progressivement diminuée de manière à assurer une transition la plus adiabatique possible du mode de propagation entre les deux parties épaisse (zone 41) et amincie (zone 43) de ce guide, la structure de ce mode étant lentement modifiée d'un état confiné (zone 41) à un état déconfiné (zone 43).

Par ailleurs, le guide passif ainsi réalisé peut être enterré dans une couche de gaine 54 réalisée dans de l'InP par exemple, comme illustré sur la figure 2D.

Après avoir réalisé cette étape d'épitaxie sélective, les masques 31, 32, à la surface desquels aucun matériau n'a été déposé, sont éliminés par un traitement classique haute fréquence.

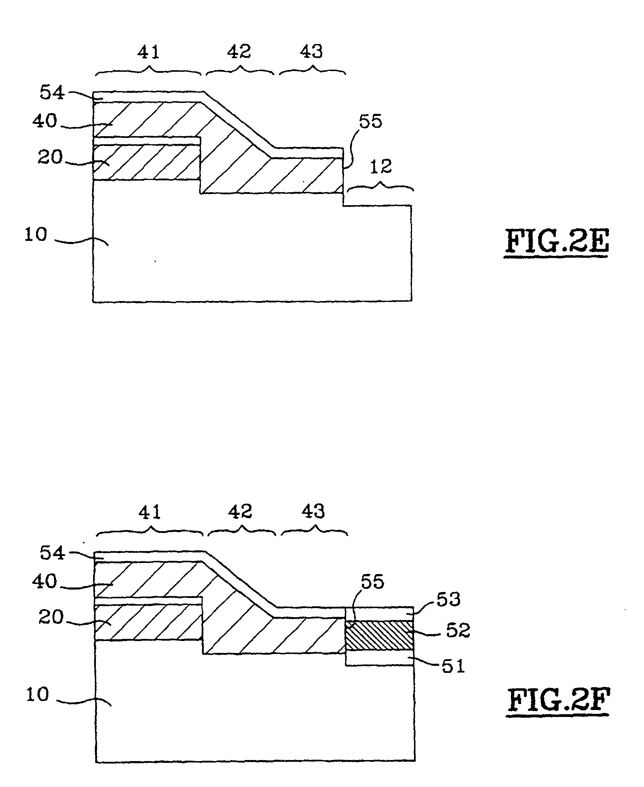

Une portion 12 de la deuxième couche guidante 40 du guide passif est ensuite gravée localement, dans la troisième zone 43, au moyen d'un procédé classique de gravure sèche, de manière à faire apparaître une surface du substrat. Cette portion 12 est réservée au guide mince actif auquel le guide d'onde passif qui vient d'être réalisé sera couplé (figure 2E).

Enfin, une autre reprise d'épitaxie est réalisée dans une dernière étape, illustrée sur la figure 2F, pour former le guide mince actif. Pour cela, une première couche en InP 51 par exemple est déposée sur le substrat, puis une troisième couche guidante 52 formant le guide mince est déposée sur la couche d'InP 51 et enterrée dans une couche de gaine supérieure 53 d'InP. La troisième couche guidante 52 est par exemple réalisée dans un matériau quaternaire ou dans une structure à multi-puits quantiques ou autre. Elle présente une épaisseur de l'ordre de 0,2-0,5µm. Cette dernière étape est réalisée de manière classique, selon la méthode connue de "butt coupling", puisque l'interface de couplage entre les deux types de guide a été transformée en une interface peu profonde 55.

La couche inférieure d'InP 51 est facultative. Elle permet de réaliser un bon alignement entre le guide passif et le guide actif. Pour cela, elle est déposée sur une épaisseur déterminée qui est de l'ordre de 0,15µm dans l'exemple de réalisation de la figure 2F.

Grâce au procédé selon l'invention l'épaisseur du guide épais est amincie pour transformer l'interface de couplage profonde entre le guide passif et le guide actif en une interface 55 peu profonde. De cette manière, la méthode classique de "butt coupling" peut être utilisée pour réaliser un couplage entre les deux types de guide d'onde.

Par conséquent, les pertes optiques dues aux difficultés de réaliser une reprise d'épitaxie après une gravure profonde sont évitées. Les pertes optiques créées à l'interface 55 sont liées au changement d'indice du guide d'onde épais, lui-même entraîné par le changement d'épaisseur. En effet, l'indice effectif du guide, c'est-à-dire l'indice réel du guide à l'interface 55, est différent de l'indice du guide dans sa partie épaisse (zone 41).

Les courbes de la figure 3 représentent les pertes de propagation, en fonction de la longueur de la section à gradient d'épaisseur 42, dans un composant selon l'invention comportant, dans un premier cas, un guide épais à gradient d'épaisseur (zone 42) et à section amincie (zone 43) et, dans un deuxième cas, un guide épais à gradient d'épaisseur (zone 42) et à section amincie (zone 43) couplé à un guide d'onde mince (52). Les pertes optiques intrinsèques au gradient d'épaisseur sont inférieures au dB. Elles sont en général de l'ordre de 0,4 dB lorsque la zone 42 a une longueur supérieure à 50µm et restent donc acceptables.

## Revendications

1. Procédé de fabrication d'un composant optique intégré comprenant un guide d'onde épais couplé à un guide d'onde mince à travers une interface de couplage (55), **caractérisé en ce qu'**il consiste à :
- déposer, sur un substrat (10), une première couche guidante (20) dudit guide épais,
- graver localement ladite première couche guidante (20) sur une partie (11) allouée à la fois à l'interface de couplage et au guide mince,
- déposer, sur la première couche guidante (20) et sur la partie gravée localement (11), une deuxième couche guidante (40) pour former ledit guide épais de telle sorte qu'il présente une épaisseur maximale dans une première zone (41), une section à gradient d'épaisseur dans une deuxième zone (42) et une section amincie dans une troisième zone (43),
- graver localement la deuxième couche guidante (40) sur une portion (12) de la troisième zone (43), ladite portion étant allouée au guide mince et
- déposer, dans ladite portion (12) de ladite troisième zone, une troisième couche guidante (52) formant ledit guide mince.

2. Procédé selon la revendication 1, **caractérisé en ce que** pour former la section à gradient d'épaisseur, deux masques diélectriques (31, 32) sont disposés sur la partie (11) gravée localement.

3. Procédé selon la revendication 2, **caractérisé en ce que** les masques (31, 32) présentent des formes trapézoïdales et **en ce qu'**ils sont placés cote à cote de sorte que la distance les séparant augmente entre la première zone (41), correspondant à la section épaisse du guide, et la troisième zone (43) correspondant à la section amincie du guide.

4. Pocédé selon l'une des revendications 2 à 3, **caractérisé en ce que** les masques (31, 32) sont réalisés en silice ou en nitrure de silicium.

5. Procédé selon l'une des revendications 1 à 4, **caractérisé en ce que** la première couche guidante (20) est déposée sur une épaisseur comprise entre 0,5 et 2,1µm, la deuxième couche guidante (40) est déposée sur une épaisseur comprise entre 0,5 et 0,9 µm et la troisième couche guidante (52) est déposée sur une épaisseur comprise entre 0,2 et 0,5µm.

6. Procédé selon l'une des revendications 1 à 5, **caractérisé en ce que** les couches guidantes sont déposées de manière à ce que l'interface de couplage (55) forme un angle quelconque avec le plan desdites couches guidantes.

## Claims

1. A method of manufacturing an integrated optical component comprising a thick waveguide coupled to a thin waveguide via a coupling interface (55), said method being **characterized in that** it consists in:
depositing a first guiding layer (20) of said thick waveguide on a substrate (10);
locally etching said first guiding layer (20) over a portion (11) allocated both to the coupling interface and to the thin waveguide;
depositing a second guiding layer (40) on the first guiding layer (20) and on the locally etched portion (11) so as to form said thick waveguide in a manner such that it has a maximum thickness in a first zone (41), a graded-thickness section in a second zone (42), and a reduced-thickness section in a third zone (43);
locally etching the second guiding layer (40) over a portion (12) of the third zone (43), said portion being allocated to the thin waveguide; and
depositing a third guiding layer (52) in said portion (12) of said third zone so as to form said thin waveguide.

2. A method according to claim 1, **characterized in that**, to form the graded-thickness section, two dielectric masks (31, 32) are disposed on the locally-etched portion (11).

3. A method according to claim 2, **characterized in that** the masks (31, 32) are trapezium shaped, and **in that** they are placed side-by-side such that the distance between them increases between the first zone (41), corresponding to the thick section of the waveguide, and the third zone (43), corresponding to the reduced-thickness section of the waveguide.

4. A method according to claim 2 or 3, **characterized in that** the masks (31, 32) are formed of silica or of silicon nitride.

5. A method according to any one of claims 1 to 4, **characterized in that** the first guiding layer (20) is deposited over a thickness lying in the range 0.5 µm to 2.1 µm, the second guiding layer (40) is deposited over a thickness lying in the range 0.5 µm to 0.9 µm, and the third guiding layer (52) is deposited over a thickness lying in the range 0.2 µm to 0.5 µm.

6. A method according to any one of claims 1 to 5, **characterized in that** the guiding layers are deposited in a manner such that the coupling interface forms an arbitrary angle with the plane of said guiding layers.

## Patentansprüche

1. Verfahren zur Herstellung eines integrierten optischen Bauteils mit einem dicken Wellenleiter, der mit einem dünnen Wellenleiter über eine Kopplungsgrenzschicht (55) gekoppelt ist, **dadurch gekennzeichnet, dass** es umfasst:
- Abscheiden einer ersten Leitungsschicht (20) des dicken Leiters auf ein Substrat (10),
- Lokales Ätzen der ersten Leitungsschicht (20) auf einem Teil (11), der zugleich der Kopplungsgrenzschicht und dem dünnen Leiter zugewiesen ist,
- Abscheiden einer zweiten Leitungsschicht (40) auf die erste Leitungsschicht (20) und auf den lokal geätzten Teil (11) um den dicken Leiter zu formen, derart, dass er eine maximale Dicke in einer ersten Zone (41), einen Abschnitt mit einem Dickengradienten in einer zweiten Zone (42) und einen dünnen Abschnitt in einer dritten Zone (43) aufweist,
- Lokales Ätzen der zweiten Leitungsschicht (40) auf einem Abschnitt (12) der dritten Zone (43), wobei der Abschnitt dem dünnen Leiter zugewiesen ist, und
- Abscheiden einer den dünnen Leiter formenden dritten Leitungsschicht (52) auf den Abschnitt (12) der dritten Zone.

2. Verfahren nach Anspruch 1, **dadurch gekennzeichnet, dass** zum Formen des Abschnitts mit Dickengradient zwei dielektrische Masken (31, 32) auf dem lokal geätzten Teil (11) angeordnet sind.

3. Verfahren nach Anspruch 2, **dadurch gekennzeichnet, dass** die Masken (31, 32) eine Trapezform aufweisen und dass sie nebeneinander platziert sind, derart dass der sie trennende Abstand zwischen der ersten Zone (41), welche dem dicken Abschnitt des Leiters entspricht, und der dritten Zone (43), welche dem dünnen Abschnitt des Leiters entspricht, zunimmt.

4. Verfahren nach einem der Ansprüche 2 bis 3, **dadurch gekennzeichnet, dass** die Masken (31, 32) aus Siliziumdioxid oder aus Siliziumnitrid gefertigt sind.

5. Verfahren nach einem der Ansprüche 1 bis 4, **dadurch gekennzeichnet, dass** die erste Leitungsschicht (20) in einer Dicke zwischen 0,5 und 2,1 µm abgeschieden wird, die zweite Leitungsschicht (40) in einer Dicke zwischen 0,5 und 0,9 µm abgeschieden wird, und die dritte Leitungsschicht (52) in einer Dicke zwischen 0,2 und 0,5 µm abgeschieden wird.

6. Verfahren nach einem der Ansprüche 1 bis 5, **dadurch gekennzeichnet, dass** die Leitungsschichten derart abgeschieden werden, dass die Kopplungsgrenzschicht (55) einen beliebigen Winkel mit der Ebene der Leitungsschichten formt.
